# EUROPÄISCHE PATENTSCHRIFT

(11) **EP 1 953 908 B1**
(45) Veröffentlichungstag und Bekanntmachung des Hinweises auf die Patenterteilung: **27.03.2013**
(21) Anmeldenummer: 08001280.0
(22) Anmeldetag: 24.01.2008
(51) Int. Cl.: H02M 7/00, H05K 7/10

(54) **Trägermodul für einen Wechselrichter**
Carrier module for an inverter
Module de support pour un onduleur

(30) Priorität: 30.01.2007 DE 102007005436
(43) Veröffentlichungstag der Anmeldung: 06.08.2008
(73) Patentinhaber: Diehl AKO Stiftung & Co. KG, 88239 Wangen im Allgäu (DE)
(72) Erfinder: Illerhaus, Edmund, 88368 Bergatreute (DE); Köhler, Claus, 88299 Leutkirch (DE)
(74) Vertreter: Diehl Patentabteilung

(56) Entgegenhaltungen:
- EP-A1- 0 949 752
- DE-B- 1 233 039
- DE-U1-202006 009 906
- US-A- 5 973 947

## Beschreibung

Die vorliegende Erfindung betrifft ein Trägermodul für einen Wechselrichter sowie eine Wechselrichtereinheit mit mehreren solchen Trägermodulen.

Für große Photovoltaikanlagen werden derzeit so genannte Zentralwechselrichter verwendet, die in der Lage sind, sehr große elektrische Leistungen zu verarbeiten. Solche Anlagen werden nicht nur auf Gebäudedächern, sondern auch in Form von Freilandanlagen realisiert. Für die entsprechenden Zentralwechselrichter muss dann ein ausreichender Wetterschutz vorhanden sein.

Anstelle eines leistungsstarken Zentralwechselrichters können grundsätzlich auch mehrere einzelne String-Wechselrichter verwendet werden, die aufgrund der möglichen Serienfertigung insgesamt deutlich kostengünstiger als ein großer Zentralwechselrichter sind. Die DE 20 2006 009 906 U1 schlägt hierzu zum Beispiel ein Gestell zur Aufnahme mehrerer Wechselrichter vor, wobei die einzelnen Wechselrichter lösbar an dem Gestell anbringbar sind und das Gestell auch einen Klemmenblock für Stromkabel der Photovoltaikanlage aufweist. Ein anderes Beispiel ist aus dem EP 0 949 752 A1 bekannt.

Der vorliegenden Erfindung liegt die Aufgabe zugrunde, eine Möglichkeit zur Verwendung von mehreren einzelnen String-Wechselrichtern anstelle eines leistungsstarken Zentralwechselrichters zu schaffen, die gegenüber der aus der DE 20 2006 009 906 U1 bekannten Wechselrichtereinheit weitere Vorteile bietet.

Diese Aufgabe wird gelöst durch ein Trägermodul für einen Wechselrichter mit den Merkmalen des Anspruchs 1. Vorteilhafte Ausgestaltungen und Weiterbildungen der Erfindung sind Gegenstand der abhängigen Ansprüche.

Das Trägermodul für einen Wechselrichter umfasst ein Gehäuseelement mit einer zur Vorderseite offenen Ausnehmung zur Aufnahme eines einzelnen Wechselrichters. Zum Aufbau einer Wechselrichtereinheit aus mehreren Trägermodulen sind a) die Oberseite und die Unterseite des Gehäuseelements komplementär zueinander ausgebildet, b) die rechte Seite und die linke Seite des Gehäuseelements komplementär zueinander ausgebildet sind, und/oder c) die Rückseite des Gehäuseelements eigenkomplementär ausgebildet; und die jeweilige(n) Seite(n) des Gehäuseelements ist/sind jeweils mit wenigstens einer Verbindungseinrichtung versehen.

Mehrere solcher Trägermodule können auf einfache Weise übereinander, nebeneinander und/oder rückseitig gegeneinander angeordnet und miteinander verbunden werden, um eine Wechselrichtereinheit mit mehreren einzelnen String-Wechselrichtern aufzubauen, die für große Photovoltaikanlagen geeignet ist. Die Vorteile dieser Trägermodule der Erfindung liegen in ihrer Modularität und damit dem variablen und flexiblen Aufbau von unterschiedlichen Wechselrichtereinheiten, die an die jeweiligen Gegebenheiten optimal angepasst werden können; ihrem einfachen und damit kostengünstigen Aufbau; ihrem einfachen Verbinden miteinander zu einer größeren Wechselrichtereinheit; ihrer einfachen und platzsparenden Lagerung und Transportierbarkeit; und der einfachen Installation der Wechselrichtereinheiten vor Ort.

In einer Ausgestaltung der Erfindung weist das Trägermodul ferner einen Deckel zum Verschließen der Ausnehmung auf, sodass das Trägermodul auch einen ausreichenden Wetterschutz für den in die Ausnehmung eingesetzten Wechselrichter bietet und damit der problemlose Einsatz in Freilandanlagen ohne zusätzliche Wetterschutzmaßnahmen und auch von Wechselrichtern, die von ihrem Schutzgrad her nicht für Freilandbetrieb geeignet sind, ermöglicht ist. Der Deckel ist vorzugsweise an dem Gehäuseelement zwischen einer Öffnungs- und einer Schließstellung schwenkbar befestigt und in seiner Schließstellung zum Diebstahlschutz verriegelbar.

In einer Ausgestaltung der Erfindung ist die Verbindungseinrichtung ein Loch für eine Schraubverbindung, sodass die Trägermodule einfach miteinander verschraubt werden können.

In einer weiteren Ausgestaltung der Erfindung sind das Gehäuseelement und seine Ausnehmung derart ausgebildet, dass der Wechselrichter derart geneigt in die Ausnehmung aufnehmbar ist, dass sein oberes Ende weiter innen im Gehäuseelement angeordnet ist als sein unteres Ende. Diese Konstruktion ermöglicht ein einfacheres Einsetzen des Wechselrichters in das Trägermodul und vereinfacht die Kühlluftführung für den in die Ausnehmung eingesetzten Wechselrichter. So weist das Gehäuseelement zum Beispiel einen Kühlluftpfad zum Kühlen des in die Ausnehmung eingesetzten Wechselrichters auf, der eine Eintrittsöffnung im unteren Bereich der Vorderseite des Gehäuseelements und eine Austrittsöffnung im oberen Bereich der Rückseite des Gehäuseelements besitzt. Bei dieser Kühlluftführung wird auf einfache Weise verhindert, dass die erwärmte Kühlluft eines unteren Trägermoduls durch ein oberes Trägermodul strömt.

In einer noch weiteren Ausgestaltung der Erfindung ist das Gehäuseelement mit integrierten Kabelkanälen und einer Vielzahl von Befestigungspunkten zum Anbringen weiterer Komponenten versehen. Diese Konstruktion des Trägermoduls erlaubt ein einfaches Integrieren von weiteren Peripheriegeräten und die problemlose Anpassung des Trägermoduls bzw. der damit aufgebauten Wechselrichtereinheit an spezielle Anforderungen.

Um ein genaueres gegenseitiges Positionieren der einzelnen Trägermodule vor ihrer endgültigen Verbindung zu einer Wechselrichtereinheit zu ermöglichen, können die jeweilige(n) Seite(n) des Gehäuseelements jeweils zusätzlich mit einer Aussparung und einem Vorsprung, die komplementär zueinander angeordnet und ausgebildet sind, versehen sein.

Bei einer Wechselrichtereinheit mit mehreren solchen Trägermodulen, die übereinander, nebeneinander und/oder rückseitig gegeneinander angeordnet und miteinander verbunden sind, sind die mehreren Trägermodule vorzugsweise miteinander verschraubt; die untersten Trägermodule der Wechselrichtereinheit können jeweils auf einem Sockel befestigt sein, dessen Oberseite komplementär zur Unterseite des Gehäuseelements der Trägermodule ausgebildet ist; und es kann eine Verriegelungseinrichtung für die gesamte Wechselrichtereinheit als Diebstahlschutz vorgesehen sein.

Obige sowie weitere Merkmale und Vorteile der Erfindung werden aus der nachfolgenden Beschreibung eines bevorzugten, nicht-einschränkenden Ausführungsbeispiels unter Bezug auf die beiliegenden Zeichnungen besser verständlich. Darin zeigen:
- Fig. 1A: eine Perspektivansicht eines Trägermoduls für einen Wechselrichter gemäß einem bevorzugten Ausführungsbeispiel der vorliegenden Erfindung;
- Fig. 1B: eine Perspektivansicht des Trägermoduls von Fig. 1A mit einem eingesetzten Wechselrichter;
- Fig. 1C: eine Perspektivansicht des Trägermoduls von Fig. 1C mit einem Deckel in seiner Schließstellung;
- Fig. 2: eine Perspektivansicht einer aus mehreren Trägermodulen von Fig. 1 zusammengesetzten Wechselrichtereinheit; und
- Fig. 3: eine Schnittansicht der Wechselrichtereinheit von Fig. 2 zur Veranschaulichung der Kühlluftpfade durch die Trägermodule von Fig. 1.

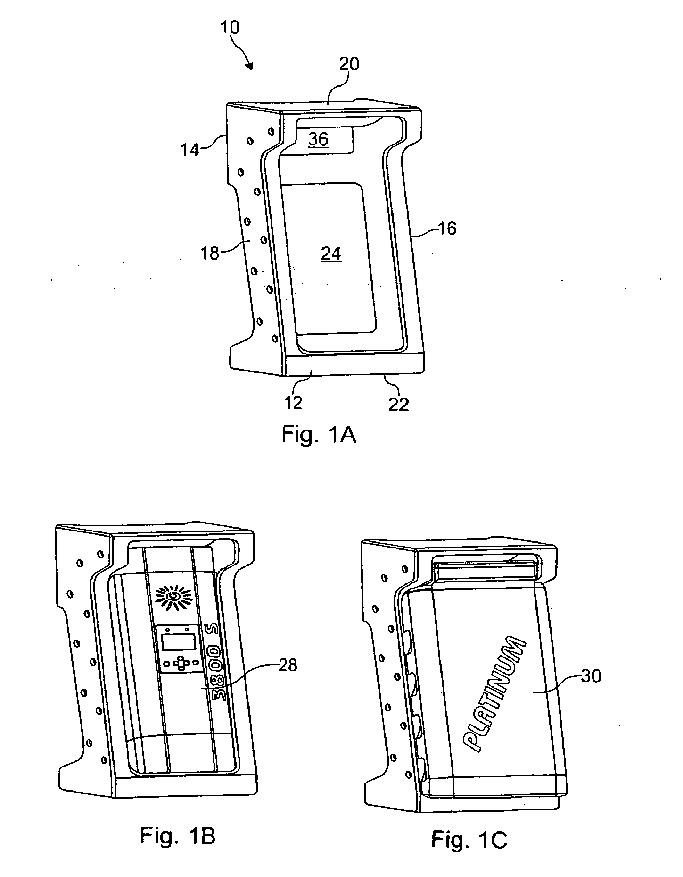

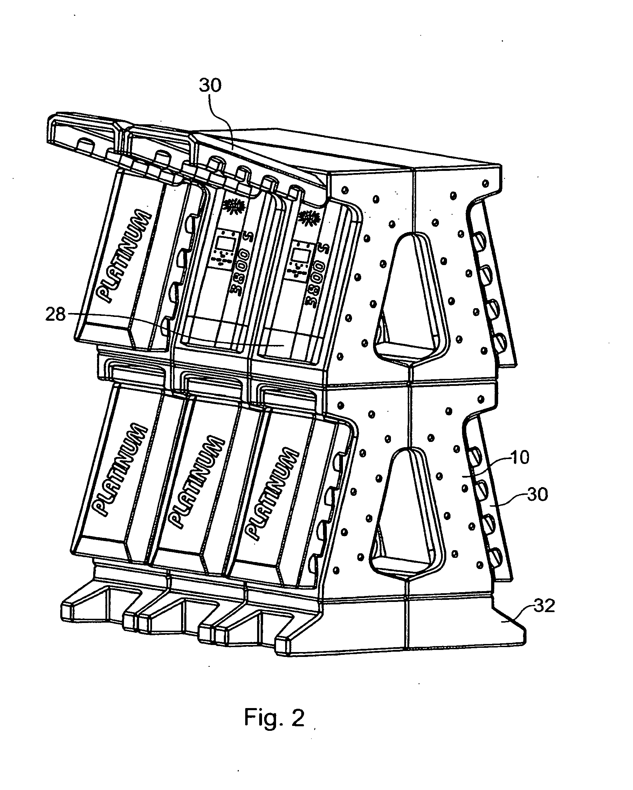

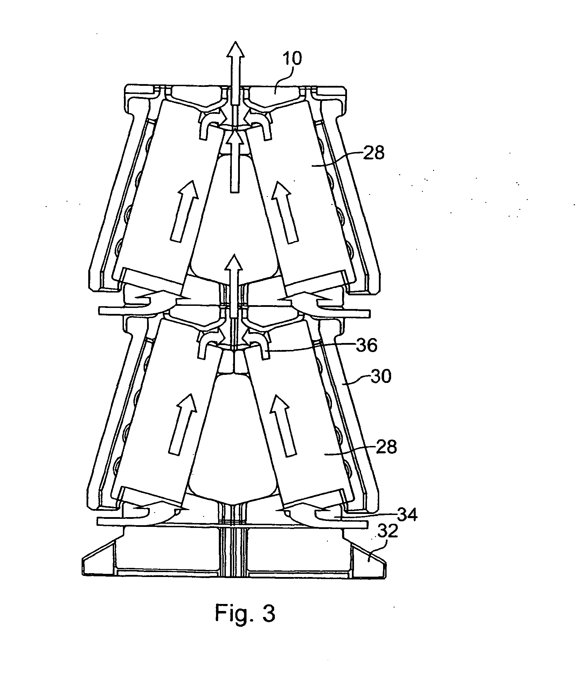

Anhand der Fig. 1A, 1B und 1C wird zunächst der Aufbau eines Trägermoduls gemäß einem bevorzugten Ausführungsbeispiel näher erläutert. Unter Bezug auf Fig. 2 wird anschließend der Aufbau einer Wechselrichtereinheit aus mehreren solchen Trägermodulen beschrieben; und Fig. 3 zeigt schließlich die vorteilhafte Kühlung der Wechselrichter in einer derart aufgebauten Wechselrichtereinheit.

Das in Fig. 1 (1A, 1B, 1C) dargestellte Trägermodul besteht aus einem Gehäuseelement 10, das zum Beispiel aus Polyethylen im so genannten Schleudergussverfahren gefertigt ist, und einem Deckel 30, der zum Beispiel aus Polypropylen im Partikelschaumverfahren gefertigt ist. Im Rahmen der Erfindung sind aber selbstverständlich auch andere Werkstoffe und Fertigungstechniken für diese Komponenten möglich.

Das Gehäuseelement 10 besitzt eine Vorderseite 12, eine Rückseite 14, eine rechte Seite 16, eine linke Seite 18, eine Oberseite 20, eine Unterseite 22 und eine Ausnehmung 24 (siehe insbesondere Fig. 1A). In die Ausnehmung 24 ist ein einzelner String-Wechselrichter 28 einsetzbar (siehe Fig. 1B). Dabei ist der Wechselrichter 28 in dem Trägermodul so geneigt angeordnet, dass sein oberes Ende weiter innen im Gehäuseelement 10 angeordnet ist als sein unteres Ende.

Die Ausnehmung 24 (mit dem darin eingesetzten Wechselrichter 28) ist vorzugsweise durch einen Deckel 30 verschließbar. Dieser Deckel 30 ist an dem Gehäuseelement 10 so befestigt, dass er zwischen einer Öffnungsstellung, in welcher der Wechselrichter 28 in die Ausnehmung eingesetzt und entfernt werden kann, und einer Schließstellung, in welcher der Wechselrichter 28 im Gehäuseelement 10 geschützt ist, schwenkbar ist (siehe auch Fig. 2). Durch den Deckel 30 kann das Trägermodul auf einfache Weise einen Wetterschutz bereitstellen, ohne dass weitere Zusatzmaßnahmen wie beispielsweise ein Schutzhäuschen getroffen werden müssten. Eine nicht dargestellte Schließvorrichtung kann bei Bedarf mit einem Schloss verriegelt werden, so dass ein gewisser Diebstahlschutz entsteht (natürlich im Rahmen der Festigkeit des Deckelwerkstoffes).

Obwohl dies in den Zeichnungen nicht dargestellt bzw. nicht erkennbar ist, ist das Gehäuseelement bevorzugt mit integrierten Kabelkanälen und einer Vielzahl von Befestigungspunkten versehen, wodurch in das Trägermodul bei Bedarf auch weitere Peripheriegeräte (Trennschalter, Fernüberwachung, Blitzschutz, Sicherungsautomaten, usw.) integriert werden können. Durch die diversen Befestigungspunkte, die nie alle gleichzeitig genutzt werden, ergibt sich eine Vielzahl von Improvisationslösungen, falls bei der Installation vor Ort spezielle Probleme (besondere räumliche Verhältnisse, spezielle Zusatzgeräte, usw.) gelöst werden müssen.

Da jeder Wechselrichter 28 mit seinem serienmäßigen Stecker angeschlossen wird, der entweder über eine Öffnung im Gehäuseelement 10 des Trägermoduls zugänglich ist oder mit einem am Gehäuseelement 10 vorgesehenen Steckverbinder verbunden wird, ist ein Austauschen eines Wechselrichters 28 innerhalb kürzester Zeit auch ohne ausgebildetes Fachpersonal möglich.

Wie in den Darstellungen der Fig. 1 bis 3 erkennbar, ist der Wechselrichter 28 so in die Ausnehmung 24 des Gehäuseelements 10 einsetzbar, dass der Wechselrichter 28 geneigt im Trägermodul liegt. Insbesondere ist der Wechselrichter 28 so geneigt, dass sein oberes Ende weiter innen im Gehäuseelement 10 angeordnet ist als sein unteres Ende. Diese Konstruktion ermöglicht ein einfacheres Einsetzen des Wechselrichters 28 in das Trägermodul und vereinfacht auch die Kühlluftführung für den in die Ausnehmung eingesetzten Wechselrichter, die später beschrieben wird.

Fig. 2 zeigt ein Beispiel, wie mehrere (hier zwölf) Trägermodule zu einer großen Wechselrichtereinheit mit großer Gesamtleistung kombiniert werden können. In dem gezeigten Beispiel sind jeweils zwei Trägermodule übereinander, drei Trägermodule nebeneinander und zwei Trägermodule rückseitig gegeneinander angeordnet. Die Trägermodule sind dabei vorzugsweise über Schraubverbindungen durch in den Gehäuseelementen 10 vorgesehene Löcher (Verbindungseinrichtung der Erfindung) fest verbunden.

Um die mehreren Trägermodule in der gezeigten Weise zu einer Wechselrichtereinheit kombinieren zu können, sind die Oberseite 20 und die Unterseite 22 des Gehäuseelements 10 der Trägermodule komplementär zueinander ausgebildet, sind die rechte Seite 16 und die linke Seite 18 des Gehäuseelements 10 der Trägermodule komplementär zueinander ausgebildet, und ist die Rückseite 14 des Gehäuseelements 10 der Trägermodule eigenkomplementär ausgebildet, sodass die jeweiligen Seiten gut zusammenpassen. Um den Zusammenbau der Wechselrichtereinheit zu erleichtern, können die jeweiligen Seiten 14-22 des Gehäuseelements 10 zusätzlich mit Aussparungen und Vorsprüngen (nicht dargestellt) versehen sein, die komplementär zueinander angeordnet und ausgebildet sind, um eine exakte Vorpositionierung vor der eigentlichen Verbindung der Trägermodule miteinander zu ermöglichen.

Wie in Fig. 2 dargestellt, sind die untersten Trägermodule jeweils auf einem Sockel 32 montiert. Hierzu ist die Oberseite des Sockels komplementär zur Unterseite 22 des Gehäuseelements 10 der Trägermodule ausgebildet.

Obwohl in den Zeichnungen nicht dargestellt, kann in der Wechselrichtereinheit zum Diebstahlschutz eine Verriegelungsvorrichtung vorhanden sein. Diese Verriegelungsvorrichtung ist zum Beispiel eine Verriegelungsstange, die quer durch die gesamte Einheit verläuft.

Falls die Anzahl von Zusatzgeräten für die Wechselrichtereinheit sehr groß ist, kann es auch sinnvoll sein, in ein Trägermodul sämtliche Zusatzgeräte (DC-Trenner, Sicherungshauptschalter, Stromzähler, Blitzschutz, Internetanbindung, usw.) für die gesamte Wechselrichtereinheit einzubauen.

Unter Bezug auf Fig. 3 wird nun der Kühlluftpfad zum Kühlen des in die die Ausnehmung 24 eingesetzten Wechselrichters 28 in den Trägermodulen der Erfindung näher erläutert.

Der Kühlluftpfad weist eine Eintrittsöffnung 34 im unteren Bereich der Vorderseite 12 des Gehäuseelements 10 und eine Austrittsöffnung 36 (siehe auch. Fig. 1A) im oberen Bereich der Rückseite 14 des Gehäuseelements 10 auf. Wie durch die Pfeile in Fig. 3 angedeutet, wird bei dieser Kühlluftführung auf einfache Weise verhindert, dass die von einem unteren Trägermodul erwärmte Kühlluft durch ein oberes Trägermodul strömt und dabei den oberen Wechselrichter 28 erwärmt. Die durch die Wechselrichter 28 erwärmte Kühlluft strömt in der Mitte der Wechselrichtereinheit nach oben aus dieser heraus.

Der besondere Vorteil der vorliegenden Erfindung liegt in der Modularität der einzelnen Trägermodule und damit dem variablen und flexiblen Aufbau von unterschiedlichen Wechselrichtereinheiten, die an die jeweiligen Gegebenheiten optimal angepasst werden können. Die Trägermodule sind einfach und damit kostengünstig aufgebaut, und sie können einfachen miteinander zu einer größeren Wechselrichtereinheit verbunden werden. Bestehende Wechselrichtereinheiten können problemlos erweitert oder verkleinert werden. Die einzelnen Trägermodule sind auch einfach zu Lagern und zu transportieren. Durch eine Vorverdrahtung bzw. Vorkonfektionierung der Trägermodule mit Peripheriegeräten in größeren Einheiten ist eine schnelle Installation des gesamten Verbundes vor Ort auch ohne ausgebildete Fachkräfte problemlos möglich.

## Patentansprüche

1. Trägermodul für einen Wechselrichter, mit einem Gehäuseelement (10) mit einer zur Vorderseite (12) offenen Ausnehmung (24) zur Aufnahme eines einzelnen Wechselrichters (28), **dadurch gekennzeichnet, dass**
(a) die Oberseite (20) und die Unterseite (22) des Gehäuseelements (10) komplementär zueinander ausgebildet sind, b) die rechte Seite (16) und die linke Seite (18) des Gehäuseelements (10) komplementär zueinander ausgebildet sind, und/oder c) die Rückseite (14) des Gehäuseelements (10) eigenkomplementär ausgebildet ist; und
wobei die jeweilige(n) Seite(n) (14; 16, 18; 20, 22) des Gehäuseelements jeweils mit wenigstens einer Verbindungseinrichtung versehen ist/sind.

2. Trägermodul für einen Wechselrichter nach Anspruch 1,
**dadurch gekennzeichnet,**
**dass** das Trägermodul ferner einen Deckel (30) zum Verschließen der Ausnehmung (24) aufweist.

3. Trägermodul für einen Wechselrichter nach Anspruch 2,
**dadurch gekennzeichnet,**
**dass** der Deckel (30) an dem Gehäuseelement (10) zwischen einer Öffnungs- und einer Schließstellung schwenkbar befestigt ist.

4. Trägermodul für einen Wechselrichter nach Anspruch 2 oder 3,
**dadurch gekennzeichnet,**
**dass** der Deckel (30) in seiner Schließstellung verriegelbar ist.

5. Trägermodul für einen Wechselrichter nach einem der Ansprüche 1 bis 4,
**dadurch gekennzeichnet,**
**dass** die Verbindungseinrichtung ein Loch für eine Schraubverbindung ist.

6. Trägermodul für einen Wechselrichter nach einem der Ansprüche 1 bis 5,
**dadurch gekennzeichnet,**
**dass** das Gehäuseelement (10) und seine Ausnehmung (24) derart ausgebindet sind, dass der Wechselrichter (28) derart geneigt in die Ausnehmung (24) aufnehmbar ist, dass sein oberes Ende weiter innen im Gehäuseelement (10) angeordnet ist als sein unteres Ende.

7. Trägermodul für einen Wechselrichter nach einem der Ansprüche 1 bis 6,
**dadurch gekennzeichnet,**
**dass** das Gehäuseelement (10) ferner einen Kühlluftpfad zum Kühlen eines in die Ausnehmung (24) eingesetzten Wechselrichters (28) aufweist, wobei der Kühlluftpfad eine Eintrittsöffnung (34) im unteren Bereich der Vorderseite (12) des Gehäuseelements (10) und eine Austrittsöffnung (36) im oberen Bereich der Rückseite (14) des Gehäuseelements (10) aufweist.

8. Trägermodul für einen Wechselrichter nach einem der Ansprüche 1 bis 7,
**dadurch gekennzeichnet,**
**dass** das Gehäuseelement (10) mit integrierten Kabelkanälen versehen ist.

9. Trägermodul für einen Wechselrichter nach einem der Ansprüche 1 bis 8,
**dadurch gekennzeichnet,**
**dass** das Gehäuseelement (10) mit einer Vielzahl von Befestigungspunkten zum Anbringen weiterer Komponenten versehen ist.

10. Trägermodul für einen Wechselrichter nach einem der Ansprüche 1 bis 9,
**dadurch gekennzeichnet,**
**dass** die jeweilige(n) Seite(n) (14; 16, 18; 20, 22) des Gehäuseelements jeweils mit einer Aussparung und einem Vorsprung, die komplementär zueinander angeordnet und ausgebildet sind, versehen ist/sind.

11. Wechselrichtereinheit mit mehreren Trägermodulen nach einem der Ansprüche 1 bis 10, die übereinander, nebeneinander und/oder rückseitig gegeneinander angeordnet und miteinander verbunden sind.

12. Wechselrichtereinheit nach Anspruch 11,
**dadurch gekennzeichnet,**
**dass** die mehreren Trägermodule miteinander verschraubt sind.

13. Wechselrichtereinheit nach Anspruch 11 oder 12,
**dadurch gekennzeichnet,**
**dass** die untersten Trägermodule der Wechselrichtereinheit jeweils auf einem Sockel (32) befestigt sind, dessen Oberseite komplementär zur Unterseite (12) des Gehäuseelements (10) der Trägermodule ausgebildet ist.

14. Wechselrichtereinheit nach einem der Ansprüche 11 bis 13,
**gekennzeichnet durch**
eine Verriegelungseinrichtung für die gesamte Wechselrichtereinheit.

## Claims

1. Mount module for an inverter, having a housing element (10) with a recess (24), which is open to the front face (12), for holding a single inverter (28), **characterized in that**
a) the upper face (20) and the lower face (22) of the housing element (10) are designed to be complementary to one another, b) the right-hand side (16) and the left-hand side (18) of the housing element (10) are designed to be complementary to one another, and/or c) the rear face (14) of the housing element (10) is designed to be intrinsically complementary; and
with the respective side, sides, face or faces (14; 16, 18; 20, 22) of the housing element each being provided with at least one connection device.

2. Mount module for an inverter according to Claim 1,
**characterized**
**in that** the mount module also has a cover (30) for closing the recess (24).

3. Mount module for an inverter according to Claim 2,
**characterized**
**in that** the cover (30) is attached to the housing element (10) such that it can pivot between an open position and a closed position.

4. Mount module for an inverter according to Claim 2 or 3,
**characterized**
**in that** the cover (30) can be locked in its closed position.

5. Mount module for an inverter according to one of Claims 1 to 4,
**characterized**
**in that** the connection device is a hole for a screw connection.

6. Mount module for an inverter according to one of Claims 1 to 5,
**characterized**
**in that** the housing element (10) and its recess (24) are designed such that the inverter (28) can be held at an angle in the recess (24) such that its upper end is arranged further inwards in the housing element (10) than its lower end.

7. Mount module for an inverter according to one of Claims 1 to 6,
**characterized**
**in that** the housing element (10) furthermore has a cooling air path for cooling an inverter (28) which has been inserted into the recess (24), with the cooling air path having an inlet opening (34) in the lower area of the front face (12) of the housing element (10), and an outlet opening (36) in the upper area of the rear face (14) of the housing element (10).

8. Mount module for an inverter according to one of Claims 1 to 7,
**characterized**
**in that** the housing element (10) is provided with integrated cable channels.

9. Mount module for an inverter according to one of Claims 1 to 8,
**characterized**
**in that** the housing element (10) is provided with a multiplicity of attachment points for fitting further components.

10. Mount module for an inverter according to one of Claims 1 to 9,
**characterized**
**in that** the respective side, sides, face or faces (14, 16, 18, 20, 22) of the housing element is or are each provided with a cutout and a projection, which are arranged and designed to be complementary to one another.

11. Inverter unit having a plurality of mount modules according to one of Claims 1 to 10, which are arranged one above the other, alongside one another, and/or with their rear faces against one another, and are connected to one another.

12. Inverter unit according to Claim 11,
**characterized**
**in that** the plurality of mount modules are screwed to one another.

13. Inverter unit according to Claim 11 or 12,
**characterized**
**in that** the lowermost mount modules of the inverter unit are each mounted on a base (32) whose upper face is designed to be complementary to the lower face (22) of the housing element (10) of the mount modules.

14. Inverter unit according to one of Claims 11 to 13,
**characterized by**
a locking device for the entire inverter unit.

## Revendications

1. Module de support pour un onduleur, comprenant un élément de boîtier (10) avec un évidement (24) ouvert vers le côté avant (12) pour recevoir un onduleur individuel (28), **caractérisé en ce que**
a) le côté supérieur (20) et le côté inférieur (22) de l'élément de boîtier (10) sont réalisés de manière complémentaire l'un de l'autre,
b) le côté droit (16) et le côté gauche (18) de l'élément de boîtier (10) sont réalisés de manière complémentaire l'un de l'autre, et/ou
c) le côté arrière (14) de l'élément de boîtier (10) est réalisé sous forme complémentaire à lui-même ; et
le ou les côtés respectifs (14 ; 16, 18 ; 20, 22) de l'élément de boîtier est ou sont pourvus à chaque fois d'au moins un dispositif de connexion.

2. Module de support pour un onduleur selon la revendication 1,
**caractérisé en ce que**
le module de support présente en outre un couvercle (30) pour fermer l'évidement (24).

3. Module de support pour un onduleur selon la revendication 2,
**caractérisé en ce que**
le couvercle (30) est fixé de manière pivotante sur l'élément de boîtier (10) entre une position d'ouverture et une position de fermeture.

4. Module de support pour un onduleur selon la revendication 2 ou 3,
**caractérisé en ce que**
le couvercle (30) peut être verrouillé dans sa position de fermeture.

5. Module de support pour un onduleur selon l'une quelconque des revendications 1 à 4,
**caractérisé en ce que**
le dispositif de connexion est un trou pour une connexion vissée.

6. Module de support pour un onduleur selon l'une quelconque des revendications 1 à 5,
**caractérisé en ce que**
l'élément de boîtier (10) et son évidement (24) sont réalisés de telle sorte que l'onduleur (28) puisse être reçu de manière inclinée dans l'évidement (24) de telle sorte que son extrémité supérieure soit disposée plus à l'intérieur dans l'élément de boîtier (10) que son extrémité inférieure.

7. Module de support pour un onduleur selon l'une quelconque des revendications 1 à 6,
**caractérisé en ce que**
l'élément de boîtier (10) présente en outre un chemin d'air de refroidissement pour refroidir un onduleur (28) inséré dans l'évidement (24), le chemin d'air de refroidissement présentant une ouverture d'entrée (34) dans la région inférieure du côté avant (12) de l'élément de boîtier (10) et une ouverture de sortie (36) dans la région supérieure du côté arrière (14) de l'élément de boîtier (10).

8. Module de support pour un onduleur selon l'une quelconque des revendications 1 à 7,
**caractérisé en ce que**
l'élément de boîtier (10) est pourvu de conduits de câble intégrés.

9. Module de support pour un onduleur selon l'une quelconque des revendications 1 à 8,
**caractérisé en ce que**
l'élément de boîtier (10) est pourvu d'une pluralité de points de fixation pour le montage d'autres composants.

10. Module de support pour un onduleur selon l'une quelconque des revendications 1 à 9,
**caractérisé en ce que**
le ou les côtés respectifs (14 ; 16, 18 ; 20, 22) de l'élément de boîtier est/sont pourvus à chaque fois d'un évidement et d'une saillie, qui sont disposés et réalisés de manière complémentaire l'un à l'autre.

11. Unité d'onduleur comprenant plusieurs modules de support selon l'une quelconque des revendications 1 à 10, qui sont disposés les uns au-dessus des autres, les uns à côté des autres et/ou les uns contre les autres du côté arrière, et qui sont connectés les uns aux autres.

12. Unité d'onduleur selon la revendication 11,
**caractérisée en ce que**
la pluralité de modules de support sont vissés les uns aux autres.

13. Unité d'onduleur selon la revendication 11 ou 12,
**caractérisée en ce que**
les modules de support inférieurs de l'unité d'onduleur sont à chaque fois fixés sur un socle (32) dont le côté supérieur est réalisé de manière complémentaire au côté inférieur (22) de l'élément de boîtier (10) des modules de support.

14. Unité d'onduleur selon l'une quelconque des revendications 11 à 13,
**caractérisée par**
un dispositif de verrouillage pour l'ensemble de l'unité d'onduleur.
